(19) Europäisches Patentamt
European Patent Office
Office européen des brevets

(11) **EP 4 779 332 A1**

(12) **EUROPEAN PATENT APPLICATION**
published in accordance with Art. 153(4) EPC

(43) Date of publication:
**22.07.2026 Bulletin 2026/30**

(21) Application number: **25839243.0**

(22) Date of filing: **25.07.2025**

(51) International Patent Classification (IPC):
**G01R 31/327** (2006.01)

(52) Cooperative Patent Classification (CPC):
**H02H 3/044; G01R 31/3278; H02H 3/08**

(86) International application number:
**PCT/CN2025/110673**

(87) International publication number:
**WO 2026/108227 (28.05.2026 Gazette 2026/22)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **20.11.2024 CN 202411660361**

(71) Applicant: **SHENZHEN POWEROAK NEWENER
CO., LTD
Shenzhen, Guangdong 518000 (CN)**

(72) Inventors:
• **MA, Hui**
**Shenzhen, Guangdong 518000 (CN)**
• **YOU, Yongliang**
**Shenzhen, Guangdong 518000 (CN)**
• **ZHAO, Fan**
**Shenzhen, Guangdong 518000 (CN)**
• **CHEN, Feilong**
**Shenzhen, Guangdong 518000 (CN)**
• **LI, Xiangzhuang**
**Shenzhen, Guangdong 518000 (CN)**

(74) Representative: **Murgitroyd & Company
165-169 Scotland Street
Glasgow G5 8PL (GB)**

(54) **RELAY ADHESION DETECTION METHOD AND APPARATUS FOR GRID-CONNECTED POWER SYSTEM, AND DEVICE, STORAGE MEDIUM AND PRODUCT**

(57) The present application relates to a method and a device for detecting relay sticking, an apparatus, a storage medium, and a program product. The method includes: adjusting a first inverter voltage frequency of an inverter to obtain a second inverter voltage frequency, the second inverter voltage frequency being equal to a sum of the first inverter voltage frequency and a preset disturbance frequency; acquiring a plurality of voltage data points at the second inverter voltage frequency; determining a comparison value based on a difference between the grid voltage and the inverter voltage in each voltage data point; and determining a relay sticking detection result based on the comparison value and a reference value, thereby detecting whether a relay sticking fault occurs in a grid-connected power system.

A first inverter voltage frequency of the inverter is adjusted to obtain a second inverter voltage frequency. The second inverter voltage frequency is equal to a sum of the first inverter voltage frequency and a preset disturbance frequency. — S301

A plurality of voltage data points are acquired at the second inverter voltage frequency. Each voltage data point includes a grid voltage and an inverter voltage of the inverter. — S302

A comparison value is determined based on a difference between the grid voltage and the inverter voltage in each voltage data point. — S303

A relay sticking detection result is determined based on the comparison value and a reference value. — S304

FIG. 3

EP 4 779 332 A1

# EP 4 779 332 A1

**Description**

RELATED APPLICATIONS

The present application claims priority to Chinese patent application 202411660361.9 filed on November 20, 2024, and entitled "METHOD AND DEVICE FOR DETECTING RELAY STICKING IN GRID-CONNECTED POWER SYSTEM, APPARATUS, STORAGE MEDIUM, AND PROGRAM PRODUCT", the entire contents of which are incorporated herein by reference.

TECHNICAL FIELD

The present application relates to the field of power system technology, and in particular to a method and a device for detecting relay sticking, an apparatus, a storage medium, and a program product.

BACKGROUND

In the field of single-phase or three-phase grid-connected power systems, a relay is installed between an alternating-current (AC) grid and an inverter to detect and isolate a fault in the grid in time, thus reducing the impact of the fault on the entire grid. However, with prolonged use of the relay and the influence of the application environment, the relay may experience a sticking fault, that is, the relay contacts cannot open or close properly. If a relay sticking fault occurs, the inverter cannot be effectively disconnected from the grid, and any subsequent attempt to reconnect the inverter to the grid will be ineffective.

Therefore, how to detect whether a relay sticking fault occurs in the grid-connected power system has become a technical problem that needs to be solved urgently in this field.

SUMMARY

Therefore, in order to address the above-mentioned technical problems, it is necessary to provide a method and a device for detecting relay sticking, an apparatus, a storage medium, and a program product, which can detect whether a relay sticking fault occurs in a grid-connected power system.

In a first aspect, the present application provides a method for detecting relay sticking, including:

adjusting a first inverter voltage frequency of an inverter to obtain a second inverter voltage frequency, the second inverter voltage frequency being equal to a sum of the first inverter voltage frequency and a preset disturbance frequency;

acquiring a plurality of voltage data points at the second inverter voltage frequency, each voltage data point including a grid voltage and an inverter voltage of the inverter;

determining a comparison value based on a difference between the grid voltage and the inverter voltage in each voltage data point; and

determining a relay sticking detection result based on the comparison value and a reference value.

In an embodiment, determining the relay sticking detection result based on the comparison value and the reference value includes:

determining an absence of relay sticking as the relay sticking detection result when the comparison value is greater than the reference value; and

determining a presence of relay sticking as the relay sticking detection result when the comparison value is not greater than the reference value.

In an embodiment, determining the comparison value based on the difference between the grid voltage and the inverter voltage in each voltage data point includes:

determining an absolute value of the difference between the grid voltage and the inverter voltage in each voltage data point; and

determining an average of absolute values and using the average as the comparison value.

In an embodiment, the method further includes:
determining the reference value by using an objective function based on the first inverter voltage frequency, a preset rated voltage peak value of the inverter, a preset sampling period, and the preset disturbance frequency.

The objective function is:

$$Fun(n) = \sum_{r=1}^{Num} \frac{\left|Vrate*\cos(2\pi*Finv*T1*r) - Vrate*\cos[2\pi*(Finv+\Delta F)*T1*(r+n)]\right|}{Num}$$

where, $V_{rate}$ represents the preset rated voltage peak value, $F_{inv}$ represents the first inverter voltage frequency, $T1$ represents the preset sampling period, $\Delta F$ represents the preset disturbance frequency, and $Num = \dfrac{1}{Finv*T1}$, wherein $Num$ represents the number of times the inverter voltage is sampled within one inverter period of the inverter; $r$ represents an integer greater than or equal to 1 and less than or equal to $Num$, and $n$ represents a multiple of time.

In an embodiment, determining the reference value by using the objective function based on the first inverter voltage frequency, the preset rated voltage peak value of the inverter, the preset sampling period, and the preset disturbance frequency, includes:

    determining an objective curve corresponding to the objective function based on the first inverter voltage frequency, the preset rated voltage peak value, the preset sampling period, and the preset disturbance frequency; and
    using a minimum value of the objective curve as the reference value.

In an embodiment, the method further includes:

    obtaining a first function and a second function; where the first function is used to simulate the inverter voltages of the inverter at the preset rated voltage peak and at the first inverter voltage frequency, and the second function is used to simulate the inverter voltages of the inverter at the preset rated voltage peak and at the second inverter voltage frequency; and
    determining the objective function based on the first function and the second function.

The first function is $Fun1(t) = Vrate*\cos(2\pi*Finv*T1*t)$, and the second function is $Fun2(t) = Vrate*\cos[2\pi*(Finv + \Delta F)*T1*t]$.

In a second aspect, the present application further provides a device for detecting relay sticking in a grid-connected power system, including:

    an adjustment module, configured to adjust a first inverter voltage frequency of an inverter to obtain a second inverter voltage frequency, wherein the second inverter voltage frequency is equal to a sum of the first inverter voltage frequency and a preset disturbance frequency;
    an acquisition module, configured to acquire a plurality of voltage data points at the second inverter voltage frequency, wherein each voltage data point includes a grid voltage and an inverter voltage of the inverter;
    a first determining module, configured to determine a comparison value based on a difference between the grid voltage and the inverter voltage in each voltage data point; and
    a second determining module, configured to determine a relay sticking detection result based on the comparison value and a reference value.

In a third aspect, the present application further provides a computer apparatus, including a memory and a processor. The memory has a computer program stored thereon. The processor, when executing the computer program, performs steps of:

    adjusting a first inverter voltage frequency of an inverter to obtain a second inverter voltage frequency, the second inverter voltage frequency being equal to a sum of the first inverter voltage frequency and a preset disturbance frequency;
    acquiring a plurality of voltage data points at the second inverter voltage frequency, each voltage data point including a grid voltage and an inverter voltage of the inverter;
    determining a comparison value based on a difference between the grid voltage and the inverter voltage in each voltage data point; and
    determining a relay sticking detection result based on the comparison value and a reference value.

In a fourth aspect, the present application further provides a computer-readable storage medium, having a computer program stored thereon. The computer program, when executed by a processor, performs steps of:

adjusting a first inverter voltage frequency of an inverter to obtain a second inverter voltage frequency, the second inverter voltage frequency being equal to a sum of the first inverter voltage frequency and a preset disturbance frequency;

acquiring a plurality of voltage data points at the second inverter voltage frequency, each voltage data point including a grid voltage and an inverter voltage of the inverter;

determining a comparison value based on a difference between the grid voltage and the inverter voltage in each voltage data point; and

determining a relay sticking detection result based on the comparison value and a reference value.

In a fifth aspect, the present application further provides a computer program product, including a computer program. The computer program, when executed by a processor, performs steps of:

adjusting a first inverter voltage frequency of an inverter to obtain a second inverter voltage frequency, the second inverter voltage frequency being equal to a sum of the first inverter voltage frequency and a preset disturbance frequency;

acquiring a plurality of voltage data points at the second inverter voltage frequency, each voltage data point including a grid voltage and an inverter voltage of the inverter;

determining a comparison value based on a difference between the grid voltage and the inverter voltage in each voltage data point; and

determining a relay sticking detection result based on the comparison value and a reference value.

In the method and device for detecting relay sticking, the apparatus, the storage medium, and the program product, the first inverter voltage frequency of the inverter is adjusted to the second inverter voltage frequency equal to the sum of the first inverter voltage frequency and the preset disturbance frequency, and the plurality of voltage data points are acquired at the second inverter voltage frequency. Based on the difference between the grid voltage and the inverter voltage in each voltage data point, the comparison value is determined. Based on the comparison value and the reference value, the relay sticking detection result is determined, thereby detecting whether a relay sticking fault occurs in the grid-connected power system.

BRIEF DESCRIPTION OF THE DRAWINGS

To more clearly illustrate the technical solutions in the embodiments of the present application or the conventional technology, the drawings used in the description of the embodiments or the conventional technology will be briefly described below. Obviously, the drawings described below are only embodiments of the present application. For those ordinary skilled in the art, other drawings may be obtained based on the disclosed drawings without creative effort.

FIG. 1 is a view showing an internal structure of a computer apparatus provided by an embodiment of the present application;

FIG. 2 is a structural view of a single-phase grid-connected power system provided by an embodiment of the present application;

FIG. 3 is a flowchart illustrating a method for detecting relay sticking provided by an embodiment of the present application;

FIG. 4 is a flowchart illustrating a method for determining a comparison value provided by an embodiment of the present application;

FIG. 5 is a view illustrating an objective curve corresponding to an objective function provided by an embodiment of the present application;

FIG. 6 is a flowchart illustrating a method for determining a reference value provided by an embodiment of the present application;

FIG. 7 is a flowchart illustrating a method for determining an objective function provided by an embodiment of the present application;

FIG. 8 is a view showing simulation functions provided by an embodiment of the present application;

FIG. 9 is a flowchart illustrating a method for detecting relay sticking provided by another embodiment of the present application; and

FIG. 10 is a block diagram showing a structure of a device for detecting relay sticking provided by an embodiment of the present application.

DETAILED DESCRIPTION OF THE EMBODIMENTS

The technical solutions of the embodiments of the present application will be clearly and completely described below with reference to the accompanying drawings of the present application. Obviously, the described embodiments are only some embodiments, but not all embodiments of the present application. Based on the embodiments of the present application, all other embodiments obtained by those ordinary skilled in the art without creative effort are within the scope of protection of the present application.

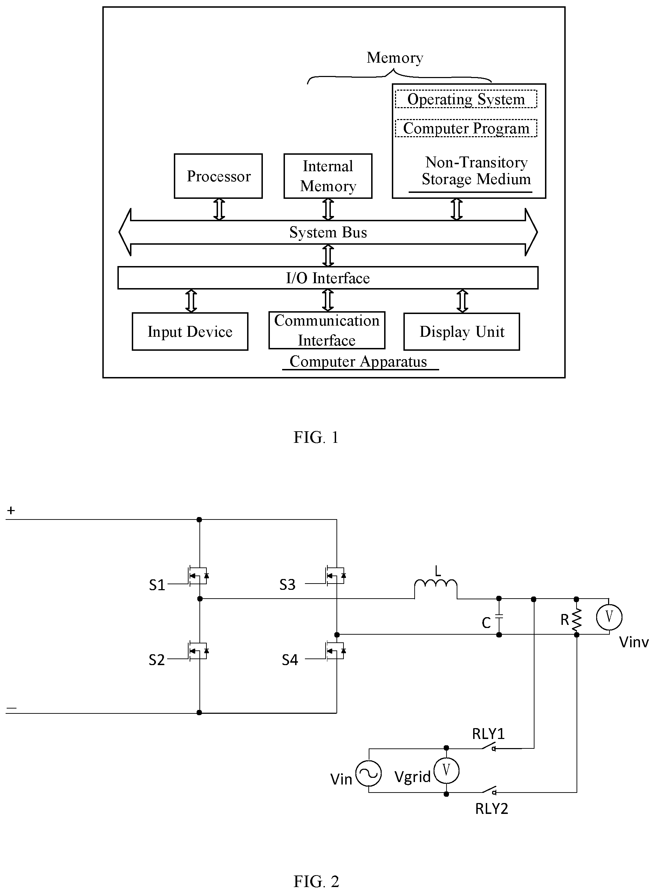

The method for detecting relay sticking provided by embodiments of the present application can be applied to a computer apparatus as shown in FIG. 1. This computer apparatus can be a terminal. FIG. 1 is a view showing an internal structure of a computer apparatus provided by an embodiment of the present application. The computer apparatus includes a processor, a memory, an input/output interface, a communication interface, a display unit, and an input device. The processor, the memory, and the input/output interface are connected via a system bus, and the communication interface, the display unit, and the input device are also connected to the system bus via the input/output interface. The processor of this computer apparatus is configured to provide computing and control capabilities. The memory of this computer apparatus includes a non-volatile storage medium and internal memory. The non-transitory storage medium stores an operating system and computer programs. The internal memory provides an environment for the operation of the operating system and computer programs in the non-transitory storage medium. The input/output interface of this computer apparatus is used for exchanging information between the processor and external devices. The communication interface of this computer apparatus is used for wired or wireless communication with external terminals. Wireless communication can be achieved through WIFI, mobile cellular networks, NFC (Near Field Communication), or other technologies. The computer program, when executed by the processor, implements a method for detecting relay sticking. The display unit of this computer apparatus is used to form a visually visible image and can be a display screen, a projection device, or a virtual reality imaging device. The display screen can be an LCD screen or an e-ink screen. The input device of this computer apparatus can be a touch layer covering the display screen, or buttons, a trackball, or a touch pad arranged on the case of the computer apparatus, or an external keyboard, external touch pad, or external mouse, etc.

Those skilled in the art can understand that the structure shown in FIG. 1 is merely a block diagram of a portion of the structure related to the present application and does not constitute a limitation on the computer apparatus to which the present application is applied. A specific computer apparatus may include more or fewer components than those shown in the figure, or may combine certain components, or may have different component arrangements.

The method for detecting relay sticking provided by the embodiments of the present application can be applied to single-phase grid-connected or three-phase grid-connected power systems. To better understand the present application, the present application is described herein in conjunction with FIG. 2. As shown in FIG.2, FIG. 2 is a structural view of a single-phase grid-connected power system provided by an embodiment of the present application. The single-phase grid-connected power system includes a first MOSFET S1, a second MOSFET S2, a third MOSFET S3, a fourth MOSFET S4, an inductor L, a capacitor C, a resistor R, a first relay RLY1, a second relay RLY2, and an AC power supply Vin. In FIG. 2, Vinv represents an inverter voltage of the inverter, Vgrid represents a grid voltage, and the first MOSFET S1, the second MOSFET S2, the third MOSFET S3, and the fourth MOSFET S4 are the switching transistors in the inverter circuit. MOS is an abbreviation for MOSFET. MOSFET stands for Metal-Oxide-Semiconductor Field-Effect Transistor. If a relay sticking fault occurs, the inverter cannot be effectively disconnected from the grid, and any subsequent attempt to reconnect the inverter to the grid will be ineffective. Therefore, how to detect whether a relay sticking fault occurs in the grid-connected power system has become a technical problem that needs to be solved urgently in this field.

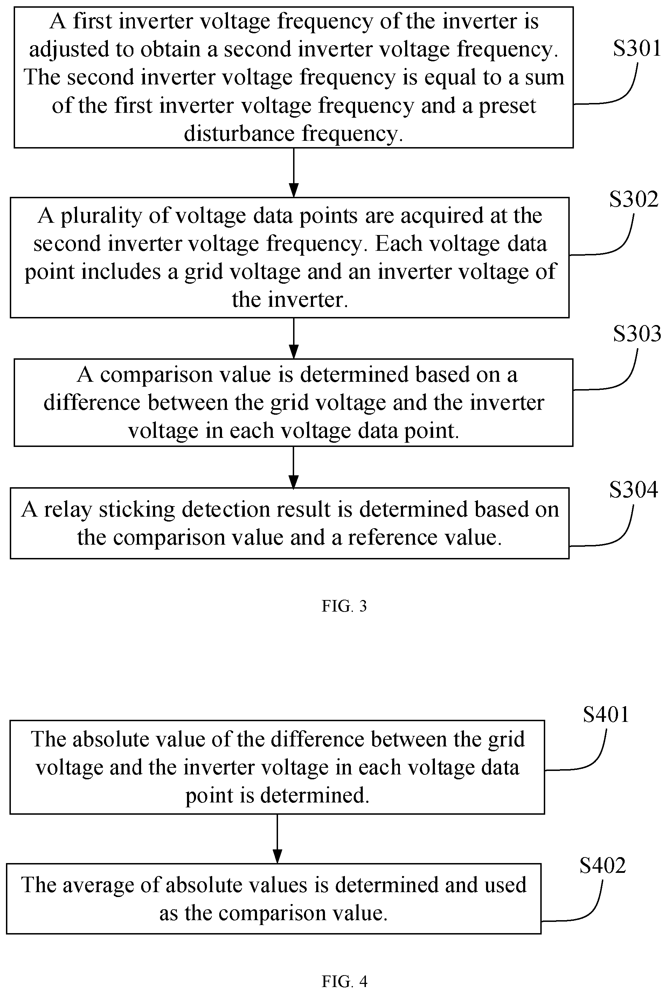

To solve the above-mentioned technical problem, in an exemplary embodiment, as shown in FIG. 3, FIG. 3 is a flowchart illustrating a method for detecting relay sticking provided by an embodiment of the present application. Taking the method applied to the computer apparatus in FIG. 1 as an example, the method includes the following steps S301 to S304.

In S301, a first inverter voltage frequency of the inverter is adjusted to obtain a second inverter voltage frequency. The second inverter voltage frequency is equal to a sum of the first inverter voltage frequency and a preset disturbance frequency.

The first inverter voltage frequency is the frequency before the inverter voltage frequency of the inverter is disturbed by using the preset disturbance frequency, and the second inverter voltage frequency is the frequency after the first inverter voltage frequency of the inverter is disturbed by using the preset disturbance frequency. In other words, the first inverter voltage frequency is adjusted by using the preset disturbance frequency, and the second inverter voltage frequency obtained by above adjustment is equal to the sum of the first inverter voltage frequency and the preset disturbance frequency. For example, if $Finv$ represents the first inverter voltage frequency and $\Delta F$ represents the preset disturbance frequency, then the second inverter voltage frequency is equal to $Finv + \Delta F$.

In S302, a plurality of voltage data points are acquired at the second inverter voltage frequency. Each voltage data point includes a grid voltage and an inverter voltage of the inverter.

After the first inverter voltage frequency of the inverter is adjusted to the second inverter voltage frequency, the inverter voltage of the inverter and the grid voltage are detected at the second inverter voltage frequency. The plurality of voltage data points can be data detected within one inverter voltage period or data detected within a plurality of inverter voltage periods. Each voltage data point includes the grid voltage and the inverter voltage of the inverter, and the grid voltage and the inverter voltage in each voltage data point are detected at the same time point.

In S303, a comparison value is determined based on a difference between the grid voltage and the inverter voltage in each voltage data point.

Determining the comparison value based on the difference between the grid voltage and the inverter voltage in each voltage data point can be achieved in the following modes.

Mode 1: the absolute value of the difference between the grid voltage and the inverter voltage in each voltage data point can be determined, an average value of absolute values is determined, and the average value is used as the comparison value.

Mode 2: the absolute value of the difference between the grid voltage and the inverter voltage in each voltage data point can be determined, and a square of an average value of absolute values is determined, and the square of the average value is used as the comparison value.

In S304, a relay sticking detection result is determined based on the comparison value and a reference value.

The reference value can be determined based on a periodic function, which can be a sine or cosine function. Inverter voltages of the inverter at a preset rated peak voltage and at the first inverter voltage frequency can be simulated by using a cosine function $A$. Alternatively, the inverter voltages at the preset rated peak voltage and at the second inverter voltage frequency can be simulated by using a cosine function $B$. Assuming the cosine function $A$ corresponds to a curve $A$ and the cosine function $B$ corresponds to a curve $B$, the curve $B$ can be shifted along the horizontal axis by a certain shift amount. An absolute value of a difference between an inverter voltage on the shifted curve $B$ and an inverter voltage on the curve $A$ is determined, and an average value of absolute values is calculated. As the shift amount of the curve $B$ shifted along the horizontal axis changes, a minimum average value is obtained and can be used as the reference value. Alternatively, a square of the minimum average value can be used as the reference value.

Similarly, the inverter voltages at the preset rated peak voltage and at the first inverter voltage frequency can be simulated by using a sine function $C$, and the inverter voltages at the preset rated peak voltage and the second inverter voltage frequency can be simulated by using a sine function $D$. Assuming the sine function $C$ corresponds to a curve $C$ and the sine function $D$ corresponds to a curve $D$, the curve $D$ can be shifted along the horizontal axis by a certain shift amount. An absolute value of a difference between an inverter voltage of the shifted curve $D$ and an inverter voltage of the curve $C$ is determined, and an average value of the absolute values is calculated. As the shift amount of the curve $D$ shifted along the horizontal axis varies, a minimum average value is obtained and can be used as the reference value. Alternatively, a square of the minimum average value can be used as the reference value.

It should be noted that if the minimum average value is used as the reference value, then the mode 1 can be used to determine the comparison value in S303. If the square of the minimum average value is used as the reference value, then the mode 2 can be used to determine the comparison value in S303.

In the methods provided by the embodiments of the present application, the first inverter voltage frequency of the inverter is adjusted to the second inverter voltage frequency equal to the sum of the first inverter voltage frequency and the preset disturbance frequency, and the plurality of voltage data points are acquired at the second inverter voltage frequency. Based on the difference between the grid voltage and the inverter voltage in each voltage data point, the comparison value is determined. Based on the comparison value and the reference value, the relay sticking detection result is determined, thereby detecting whether a relay sticking fault occurs in the grid-connected power system.

In an exemplary embodiment, the step S304 of determining the relay sticking detection result based on the comparison value and the reference value can be implemented in the following ways.

When the comparison value is greater than the reference value, an absence of relay sticking is determined as the relay sticking detection result.

When the comparison value is not greater than the reference value, a presence of relay sticking is determined as the relay sticking detection result.

When the comparison value is not greater than the reference value, it means that after the inverter voltage frequency of the inverter is disturbed by the preset disturbance frequency, the inverter voltage on the inverter side is approximate to the grid voltage, then it is determined that a relay sticking occurs.

In the methods provided by the embodiments of the present application, the relay sticking detection result can be determined by comparing the comparison value with the reference value, thereby improving the efficiency of the relay sticking detection.

In an exemplary embodiment, as shown in FIG. 4, FIG. 4 is a flowchart illustrating a method for determining a comparison value provided by an embodiment of the present application. This embodiment relates to a possible implementation of determining the comparison value based on the difference between the grid voltage and the inverter voltage in each voltage data point. Based on the above embodiments, the step S303 may include the following steps S401 and S402.

In S401, the absolute value of the difference between the grid voltage and the inverter voltage in each voltage data point is determined.

In S402, the average of absolute values is determined and used as the comparison value.

In the methods provided in the embodiments of the present application, the absolute value of the difference between the grid voltage and the inverter voltage in each voltage data point is determined, and then the average value of the absolute values is determined. The average value is used as the comparison value, and then the relay sticking detection result is determined based on the comparison value and the reference value. Since the algorithm for determining the comparison value is straightforward and requires minimal computation, thereby improving the efficiency of the relay sticking detection.

In an exemplary embodiment, the reference value is determined by using an objective function based on the first inverter voltage frequency, the preset rated voltage peak value of the inverter, a preset sampling period, and the preset disturbance frequency.

The objective function is:

$$Fun(n) = \sum_{r=1}^{Num} \frac{\left|Vrate * \cos(2\pi * Finv * T1 * r) - Vrate * \cos\left[2\pi * (Finv + \Delta F) * T1 * (r+n)\right]\right|}{Num}$$

where, $V_{rate}$ represents the preset rated voltage peak value, $F_{inv}$ represents the first inverter voltage frequency, $T1$ represents the preset sampling period, $\Delta F$ represents the preset disturbance frequency, and $Num = \dfrac{1}{Finv * T1}$, where $Num$ represents the number of times the inverter voltage is sampled within one inverter period. $r$ represents an integer greater than or equal to 1 and less than or equal to $Num$, and $n$ represents the multiple of time.

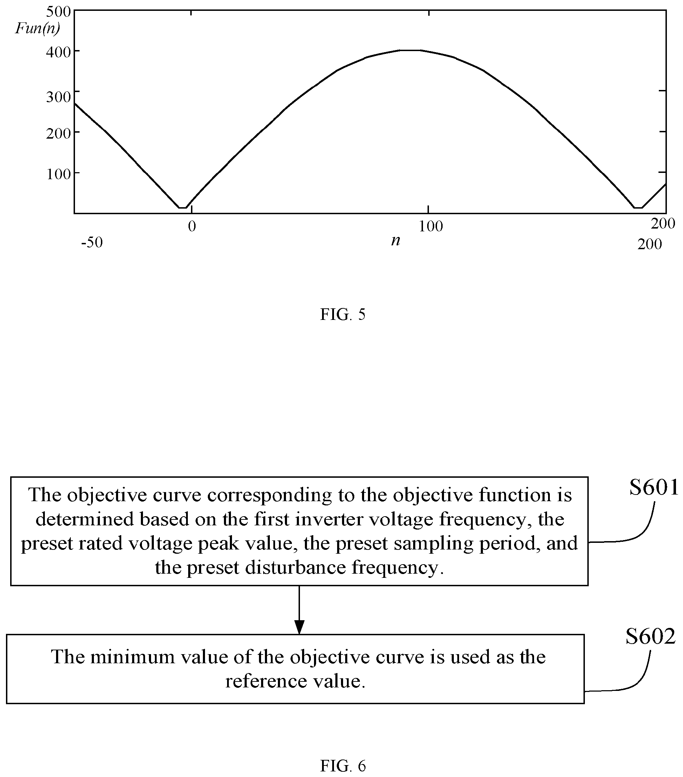

In an embodiment, taking $V_{rate}$=311v, $F_{inv}$=50 Hz, T1=100 μs, $\Delta F$=2 Hz, and $Num$ = 200 as an example, the curve corresponding to the objective function $Fun(n)$ can be seen in FIG. 5, which is a view showing an objective curve corresponding to an objective function provided by an embodiment of the present application. As shown in FIG. 5, the minimum value of $Fun(n)$ can be obtained along the position of $n$ varies, and the minimum value of $Fun(n)$ can be used as the reference value. Alternatively, the square of the minimum value of $Fun(n)$ can also be used as the reference value. $n$ represents the multiple of the time.

In the method provided by the embodiments of the present application, the reference value is determined by using the objective function based on the first inverter voltage frequency, the preset rated voltage peak value of the inverter, the preset sampling period, and the preset disturbance frequency. Then, the relay sticking detection result is determined based on the comparison value and the reference value, thereby detecting whether a relay sticking fault occurs in the grid-connected power system. Furthermore, after the reference value is determined, if a subsequent relay sticking detection is needed, the previously determined reference value can be used directly without the need for repeatedly determining the reference value, thus further improving the efficiency of the relay sticking detection.

In an exemplary embodiment, as shown in FIG. 6, FIG. 6 is a flowchart illustrating a method for determining a reference value provided by an embodiment of the present application. This embodiment relates to a possible implementation of determining the reference value by using the objective function based on the first inverter voltage frequency, the preset rated voltage peak of the inverter, the preset sampling period, and the preset disturbance frequency. Based on the above embodiments, the method may include the following steps S601 and S602.

In S601, the objective curve corresponding to the objective function is determined based on the first inverter voltage frequency, the preset rated voltage peak value, the preset sampling period, and the preset disturbance frequency.

In S602, the minimum value of the objective curve is used as the reference value.

Referring to FIG. 5, the minimum value of the objective curve can be used as the reference value. Since the objective function exhibits periodicity, the minimum value within one period of the objective function is the minimum value of the objective curve, and this minimum value can be used as the reference value.

In the method provided by the embodiments of the present application, the objective curve corresponding to the objective function is determined based on the first inverter voltage frequency, the preset rated voltage peak value, the preset sampling period, and the preset disturbance frequency. The minimum value of the objective curve is used as the reference value, and then the relay sticking detection result is determined based on the comparison value and the reference value, thereby detecting whether a relay sticking fault occurs in the grid-connected power system.

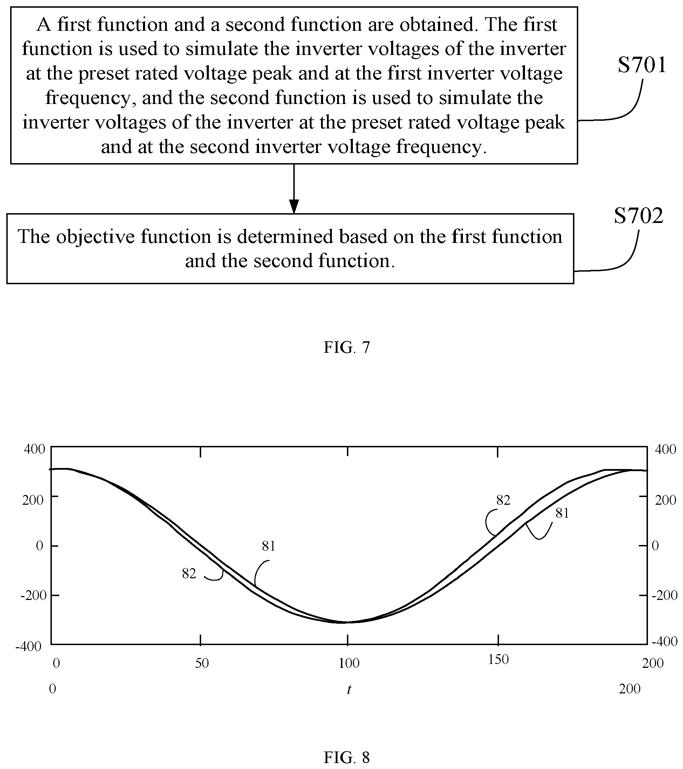

In an exemplary embodiment, as shown in FIG. 7, FIG. 7 is a flowchart illustrating a method for determining an objective function provided by an embodiment of the present application. The method includes the following steps S701 and S702.

In S701, a first function and a second function are obtained. The first function is used to simulate the inverter voltages of the inverter at the preset rated voltage peak and at the first inverter voltage frequency, and the second function is used to simulate the inverter voltages of the inverter at the preset rated voltage peak and at the second inverter voltage frequency.

The first function is $Fun1(t) = Vrate_*\cos(2\pi_*Finv_*T_*t\ Fun2(t) = Vrate_*\cos[2\pi_*(Finv + \Delta F)_*T1_*t]$.

In this embodiment, taking $V_{rate}$=311v, $F_{inv}$=50 Hz, T1=100 μs, $\Delta F$= 2 Hz as an example, as shown in FIG. 8, FIG. 8 is a view showing simulation functions provided by an embodiment of the present application. FIG. 8 shows a voltage curve in one inverter period, which is 20 ms. The first function corresponds to the curve 81, and the second function corresponds to the curve 82. T1 represents the preset sampling period, t represents a multiple of time, T1*t represents one inverter period, and t is an integer set for a processor to perform a calculation easily.

In S702, the objective function is determined based on the first function and the second function.

The objective function is used to simulate the average of the absolute values of the differences between the curve 82 and the curve 81 after the curve 82 has shifted by n along the horizontal axis.

In the method provided by embodiments of the present application, the first function and the second function are obtained, and the objective function is determined based on the first function and the second function, which lays the foundation for determining the reference value based on the objective function, thereby detecting whether a relay sticking fault occurs in the grid-connected power system based on the reference value.

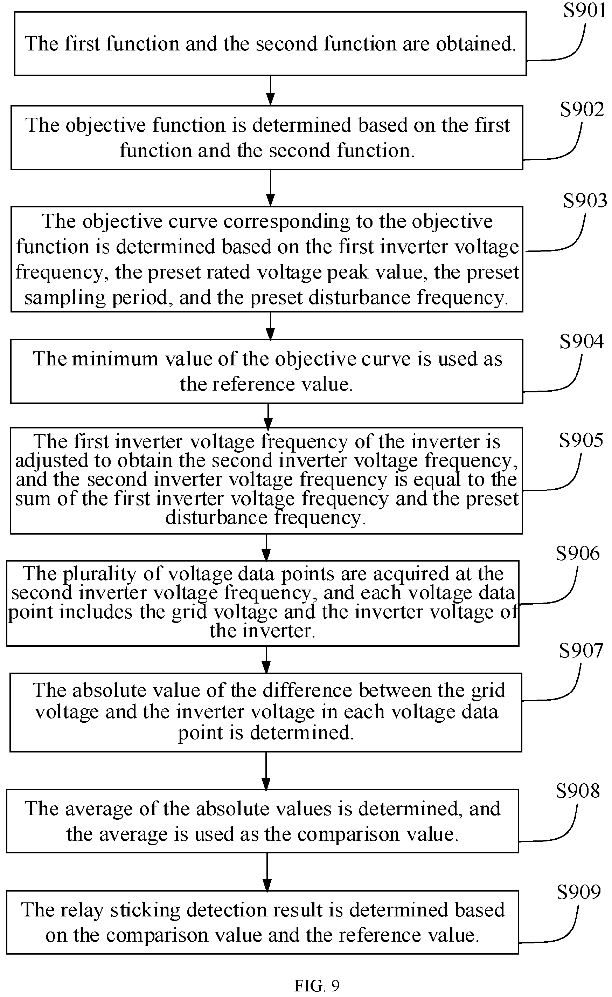

Referring to FIG. 9, FIG. 9 is a flowchart illustrating a method for detecting relay sticking provided by another embodiment of the present application, the method includes the following steps S901 to S906.

In S901, the first function and the second function are obtained.

In S902, the objective function is determined based on the first function and the second function.

In S903, the objective curve corresponding to the objective function is determined based on the first inverter voltage frequency, the preset rated voltage peak value, the preset sampling period, and the preset disturbance frequency.

In S904, the minimum value of the objective curve is used as the reference value.

In S905, the first inverter voltage frequency of the inverter is adjusted to obtain the second inverter voltage frequency, and the second inverter voltage frequency is equal to the sum of the first inverter voltage frequency and the preset disturbance frequency.

In S906, the plurality of voltage data points are acquired at the second inverter voltage frequency, and each voltage data point includes the grid voltage and the inverter voltage of the inverter.

In S907, the absolute value of the difference between the grid voltage and the inverter voltage in each voltage data point is determined.

In S908, the average of the absolute values is determined, and the average is used as the comparison value.

In S909, the relay sticking detection result is determined based on the comparison value and the reference value.

It should be understood that, although the steps in the flowcharts involved in the embodiments described above are displayed sequentially as indicated by the arrows, these steps are not necessarily executed sequentially in the order indicated by the arrows. Unless otherwise specified herein, there is no strict order limitation for the execution of these steps, and these steps may be executed in other orders. Moreover, at least a part of the steps in the flowcharts involved in the embodiments described above may include multiple steps or multiple stages. These steps or stages are not necessarily executed at the same time, but may be executed at different times. The execution order of these steps or stages is not necessarily sequential, but may be executed in turn or alternately with other steps or at least part of the steps or stages in other steps.

Based on the same inventive concept, embodiments of the present application further provide a device for detecting relay sticking to implement the methods for detecting relay sticking described above. The solutions provided by this device are similar to the solutions described in the methods above. Therefore, the specific limitations in one or more embodiments of the devices for detecting relay sticking provided hereinafter can be found in the limitations of the methods for detecting relay sticking described above, and will not be described repeatedly herein.

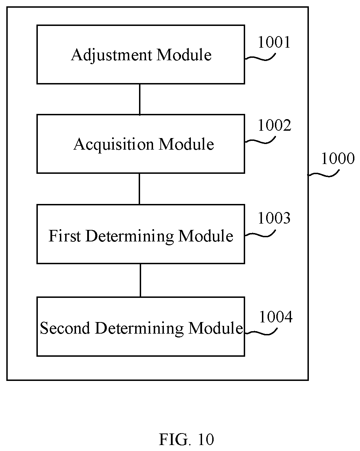

In an exemplary embodiment, as shown in FIG. 10, FIG. 10 is a block diagram showing a structure of a device for detecting relay sticking provided by an embodiment of the present application. The device 1000 includes:

an adjustment module 1001, configured to adjust a first inverter voltage frequency of the inverter to obtain a second inverter voltage frequency, where the second inverter voltage frequency is equal to a sum of the first inverter voltage frequency and a preset disturbance frequency;

an acquisition module 1002, configured to acquire a plurality of voltage data points at the second inverter voltage frequency, where each voltage data point includes a grid voltage and an inverter voltage of the inverter;

a first determining module 1003, configured to determine a comparison value based on a difference between the grid voltage and the inverter voltage in each voltage data point;

a second determining module 1004, configured to determine a relay sticking detection result based on the comparison value and a reference value.

In one of the embodiments, the second determining module 1004 is specifically configured to: when the comparison value is greater than the reference value, determine an absence of relay sticking as the relay sticking detection result; and when the comparison value is not greater than the reference value, determine a presence of relay sticking as the relay sticking detection result.

In one of the embodiments, the first determining module 1003 is specifically configured to determine the absolute value of the difference between the grid voltage and the inverter voltage in each voltage data point, and determine an average of absolute values and use the average as the comparison value.

In one of the embodiments, the device 1000 may further include a third determining module, and the third determining module is configured to determine the reference value by using an objective function based on the first inverter voltage frequency, the preset rated voltage peak value of the inverter, a preset sampling period, and the preset disturbance frequency.

The objective function is:

$$Fun(n) = \sum_{r=1}^{Num} \frac{\left|Vrate * \cos(2\pi * Finv * T1 * r) - Vrate * \cos[2\pi * (Finv + \Delta F) * T1 * (r + n)]\right|}{Num}$$

where, $V_{rate}$ represents the preset rated voltage peak value, $F_{inv}$ represents the first inverter voltage frequency, $T1$ represents the preset sampling period, $\Delta F$ represents the preset disturbance frequency, and $Num = \dfrac{1}{Finv * T1}$, where $Num$ represents the number of times the inverter voltage is sampled within one inverter period. $r$ represents an integer greater than or equal to 1 and less than or equal to $Num$, and $n$ represents the multiple of time.

In one of the embodiments, the third determining module is specifically configured to determine the objective curve corresponding to the objective function based on the first inverter voltage frequency, the preset rated voltage peak value, the preset sampling period, and the preset disturbance frequency, and use the minimum value of the objective curve as the reference value.

In one of the embodiments, the method further includes:

obtaining a first function and a second function; where the first function is used to simulate the inverter voltages of the inverter at the preset rated voltage peak and at the first inverter voltage frequency, and the second function is used to simulate the inverter voltages of the inverter at the preset rated voltage peak and at the second inverter voltage frequency;

determining the objective function based on the first function and the second function.

The first function is $Fun1(t) = Vrate*\cos(2\pi*Finv*T1*t)$, and the second function is $Fun2(t) = Vrate*\cos[2\pi*(Finv+\Delta F)*T1*t]$.

The afore-mentioned modules in the device for detecting relay sticking can be implemented entirely or partially through software, hardware, or a combination thereof. These modules can be embedded in or independent of the processor of a computer apparatus in form of hardware, or stored in the memory of the computer apparatus in form of software, so that the processor can call and execute the corresponding operations of each module.

In an exemplary embodiment, a computer apparatus is provided, including a memory and a processor. A computer program is stored on the memory, and the processor, when executing the computer program, performs the following steps:

adjusting a first inverter voltage frequency of the inverter to obtain a second inverter voltage frequency, where the second inverter voltage frequency is equal to a sum of the first inverter voltage frequency and a preset disturbance frequency;

acquiring a plurality of voltage data points at the second inverter voltage frequency, where each voltage data point includes a grid voltage and an inverter voltage of the inverter;

determining a comparison value based on a difference between the grid voltage and the inverter voltage in each voltage data point; and

determining a relay sticking detection result based on the comparison value and a reference value.

In an embodiment, the processor, when executing the computer program, further performs the following steps:

determining an absence of relay sticking as the relay sticking detection result when the comparison value is greater than the reference value; and

determining a presence of relay sticking as the relay sticking detection result when the comparison value is not greater than the reference value.

In an embodiment, the processor, when executing the computer program, further performs the following steps:

determining the absolute value of the difference between the grid voltage and the inverter voltage in each voltage data point, and
determining an average of absolute values and using the average as the comparison value.

In an embodiment, the processor, when executing the computer program, further performs the following step: determining the reference value by using an objective function based on the first inverter voltage frequency, the preset rated voltage peak value of the inverter, a preset sampling period, and the preset disturbance frequency.

The objective function is:

$$Fun(n) = \sum_{r=1}^{Num} \frac{\left|Vrate * \cos(2\pi * Finv * T1 * r) - Vrate * \cos[2\pi * (Finv + \Delta F) * T1 * (r+n)]\right|}{Num}$$

where, $V_{rate}$ represents the preset rated voltage peak value, $F_{inv}$ represents the first inverter voltage frequency, $T1$ represents the preset sampling period, $\Delta F$ represents the preset disturbance frequency, and $Num = \dfrac{1}{Finv * T1}$, where $Num$ represents the number of times the inverter voltage is sampled within one inverter period. $r$ represents an integer greater than or equal to 1 and less than or equal to $Num$, and $n$ represents the multiple of time.

In an embodiment, the processor, when executing the computer program, further performs the following steps:

determining the objective curve corresponding to the objective function based on the first inverter voltage frequency, the preset rated voltage peak value, the preset sampling period, and the preset disturbance frequency; and
using the minimum value of the objective curve as the reference value.

In an embodiment, the processor, when executing the computer program, further performs the following steps:

obtaining a first function and a second function; where the first function is used to simulate the inverter voltages of the inverter at the preset rated voltage peak and at the first inverter voltage frequency, and the second function is used to simulate the inverter voltages of the inverter at the preset rated voltage peak and at the second inverter voltage frequency; and
determining the objective function based on the first function and the second function.

The first function is $Fun1(t) = Vrate*\cos(2\pi*Finv*T1*t)$, and the second function is $Fun2(t) = Vrate*\cos[2\pi*(Finv + \Delta F)*T1*t]$.

In an embodiment, a computer-readable storage medium is provided, having a computer program stored thereon. The computer program, when executed by a processor, performs the following steps:

adjusting a first inverter voltage frequency of the inverter to obtain a second inverter voltage frequency, where the second inverter voltage frequency is equal to a sum of the first inverter voltage frequency and a preset disturbance frequency;
acquiring a plurality of voltage data points at the second inverter voltage frequency, where each voltage data point includes a grid voltage and an inverter voltage of the inverter;
determining a comparison value based on a difference between the grid voltage and the inverter voltage in each voltage data point; and
determining a relay sticking detection result based on the comparison value and a reference value.

In an embodiment, the computer program, when executed by the processor, further performs the following steps:

determining an absence of relay sticking as the relay sticking detection result when the comparison value is greater than the reference value; and
determining a presence of relay sticking as the relay sticking detection result when the comparison value is not greater than the reference value.

In an embodiment, the computer program, when executed by the processor, further performs the following steps:

determining the absolute value of the difference between the grid voltage and the inverter voltage in each voltage data point; and

determining an average of absolute values and using the average as the comparison value.

In an embodiment, the computer program, when executed by the processor, further performs the following step: determining the reference value by using an objective function based on the first inverter voltage frequency, the preset rated voltage peak value of the inverter, a preset sampling period, and the preset disturbance frequency.

The objective function is:

$$Fun(n) = \sum_{r=1}^{Num} \frac{\left| Vrate * \cos(2\pi * Finv * T1 * r) - Vrate * \cos\left[ 2\pi * (Finv + \Delta F) * T1 * (r+n) \right] \right|}{Num}$$

where, $V_{rate}$ represents the preset rated voltage peak value, $F_{inv}$ represents the first inverter voltage frequency, $T1$ represents the preset sampling period, $\Delta F$ represents the preset disturbance frequency, and $Num = \dfrac{1}{Finv * T1}$, where $Num$ represents the number of times the inverter voltage is sampled within one inverter period. $r$ represents an integer greater than or equal to 1 and less than or equal to $Num$, and $n$ represents the multiple of time.

In an embodiment, the computer program, when executed by the processor, further performs the following steps:

determining the objective curve corresponding to the objective function based on the first inverter voltage frequency, the preset rated voltage peak value, the preset sampling period, and the preset disturbance frequency, and using the minimum value of the objective curve as the reference value.

In an embodiment, the computer program, when executed by the processor, further performs the following steps:

obtaining a first function and a second function; where the first function is used to simulate the inverter voltages of the inverter at the preset rated voltage peak and at the first inverter voltage frequency, and the second function is used to simulate the inverter voltages of the inverter at the preset rated voltage peak and at the second inverter voltage frequency; and
determining the objective function based on the first function and the second function.

The first function is $Fun1(t) = Vrate*\cos(2\pi*Finv_*T1_*t)$, and the second function is $Fun2(t) = Vrate*\cos[2\pi*(Finv + \Delta F)*T1*t]$.

In an embodiment, a computer program product is provided, including a computer program. The computer program, when executed by a processor, performs the following steps:

adjusting a first inverter voltage frequency of the inverter to obtain a second inverter voltage frequency, where the second inverter voltage frequency is equal to a sum of the first inverter voltage frequency and a preset disturbance frequency;
acquiring a plurality of voltage data points at the second inverter voltage frequency, where each voltage data point includes a grid voltage and an inverter voltage of the inverter;
determining a comparison value based on a difference between the grid voltage and the inverter voltage in each voltage data point; and
determining a relay sticking detection result based on the comparison value and a reference value.

In an embodiment, the computer program, when executed by the processor, further performs the following steps: determining an absence of relay sticking as the relay sticking detection result when the comparison value is greater than the reference value; and determining a presence of relay sticking as the relay sticking detection result when the comparison value is not greater than the reference value.

In an embodiment, the computer program, when executed by the processor, further performs the following steps: determining the absolute value of the difference between the grid voltage and the inverter voltage in each voltage data point, and determining an average of absolute values and using the average as the comparison value.

In an embodiment, the computer program, when executed by the processor, further performs the following step: determining the reference value by using an objective function based on the first inverter voltage frequency, the preset rated voltage peak value of the inverter, a preset sampling period, and the preset disturbance frequency.

The objective function is:

$$Fun(n) = \sum_{r=1}^{Num} \frac{|Vrate * \cos(2\pi * Finv * T1 * r) - Vrate * \cos[2\pi * (Finv + \Delta F) * T1 * (r + n)]|}{Num} \; ;$$

where, $V_{rate}$ represents the preset rated voltage peak value, $F_{inv}$ represents the first inverter voltage frequency, $T1$ represents the preset sampling period, $\Delta F$ represents the preset disturbance frequency, and $Num = \dfrac{1}{Finv * T1}$, where $Num$ represents the number of times the inverter voltage is sampled within one inverter period. $r$ represents an integer greater than or equal to 1 and less than or equal to $Num$, and $n$ represents the multiple of time.

In an embodiment, the computer program, when executed by the processor, further performs the following steps: determining the objective curve corresponding to the objective function based on the first inverter voltage frequency, the preset rated voltage peak value, the preset sampling period, and the preset disturbance frequency, and using the minimum value of the objective curve as the reference value.

In an embodiment, the computer program, when executed by the processor, further performs the following steps:

obtaining a first function and a second function; where the first function is used to simulate the inverter voltages of the inverter at the preset rated voltage peak and at the first inverter voltage frequency, and the second function is used to simulate the inverter voltages of the inverter at the preset rated voltage peak and at the second inverter voltage frequency; and

determining the objective function based on the first function and the second function.

The first function is $Fun1(t) = Vrate*\cos(2\pi*Finv*T1*t)$, and the second function is $Fun2(t) = Vrate*\cos[2\pi*(Finv + \Delta F)*T1*t]$.

It should be noted that the user information (including but not limited to user device information, user personal information, etc.) and data (including but not limited to data used for analysis, stored data, displayed data, etc.) involved in the present application are all information and data authorized by the user or fully authorized by all parties, and the collection, use and processing of the relevant data must comply with relevant regulations.

Those ordinary skilled in the art will understand that all or part of the processes in the methods of the above embodiments may be implemented by instructing related hardware through computer-readable instructions. These computer-readable instructions may be stored in a non-transitory computer-readable storage medium. When executed, these computer-readable instructions may include the processes of the embodiments of the above methods. Any references to memory, databases, or other media used in the embodiments provided in the present application may include at least one of non-transitory and volatile memory. Non- transitory memory may include read-only memory (ROM), magnetic tape, floppy disk, flash memory, optical memory, high-density embedded non-volatile memory, resistive random-access memory (ReRAM), magnetic random-access memory (MRAM), ferroelectric random-access memory (FRAM), phase change memory (PCM), graphene memory, etc. Volatile memory may include random access memory (RAM) or external cache memory, etc. By way of illustration and not limitation, RAM may take many forms, such as Static Random Access Memory (SRAM) or Dynamic Random Access Memory (DRAM). The databases involved in the embodiments provided in the present application may include at least one of relational database and non-relational database. Non-relational databases may include, but are not limited to, blockchain-based distributed databases. The processors involved in the embodiments provided in the present application may be general-purpose processors, central processing units, graphics processing units, digital signal processors, programmable logic devices, quantum computing-based data processing logic devices, etc., and are not limited thereto.

The technical features of the above embodiments can be combined in any way. For the sake of brevity, not all possible combinations of the technical features in the above embodiments are described. However, as long as there is no contradiction in the combinations of these technical features, these combinations should be considered to be within the scope of the present application.

The embodiments described above are merely illustrative of several implementations of the present application. Although the descriptions of the embodiments are relatively specific and detailed, they should not be construed as limiting the scope of the patent application. It should be noted that, for those ordinary skilled in the art, various modifications and improvements can be made without departing from the concept of the present application, and all these modifications and improvements fall within the protection scope of the present application. Therefore, the protection scope of this patent application should be determined by the appended claims.

**Claims**

1. A method for detecting relay sticking in a grid-connected power system, **characterized by** comprising:

   adjusting a first inverter voltage frequency of an inverter to obtain a second inverter voltage frequency, the second inverter voltage frequency being equal to a sum of the first inverter voltage frequency and a preset disturbance frequency;

   acquiring a plurality of voltage data points at the second inverter voltage frequency, each voltage data point comprising a grid voltage and an inverter voltage of the inverter;

   determining a comparison value based on a difference between the grid voltage and the inverter voltage in each voltage data point; and

   determining a relay sticking detection result based on the comparison value and a reference value.

2. The method according to claim 1, wherein determining the relay sticking detection result based on the comparison value and the reference value comprises:

   determining an absence of relay sticking as the relay sticking detection result when the comparison value is greater than the reference value; and

   determining a presence of relay sticking as the relay sticking detection result when the comparison value is not greater than the reference value.

3. The method according to claim 1 or 2, wherein determining the comparison value based on the difference between the grid voltage and the inverter voltage in each voltage data point comprises:

   determining an absolute value of the difference between the grid voltage and the inverter voltage in each voltage data point; and

   determining an average of absolute values and using the average as the comparison value.

4. The method according to claim 1 or 2, further comprising:

   determining the reference value by using an objective function based on the first inverter voltage frequency, a preset rated voltage peak value of the inverter, a preset sampling period, and the preset disturbance frequency; wherein the objective function is:

$$Fun(n) = \sum_{r=1}^{Num} \frac{\left|Vrate * \cos\left(2\pi * Finv * T1 * r\right) - Vrate * \cos\left[2\pi * \left(Finv + \Delta F\right) * T1 * \left(r + n\right)\right]\right|}{Num}$$

   wherein, $V_{rate}$ represents the preset rated voltage peak value, $F_{inv}$ represents the first inverter voltage frequency, $T1$ represents the preset sampling period, $\Delta F$ represents the preset disturbance frequency, and $Num = \dfrac{1}{Finv * T1}$ , wherein $Num$ represents the number of times the inverter voltage is sampled within one inverter period of the inverter; $r$ represents an integer greater than or equal to 1 and less than or equal to $Num$, and $n$ represents a multiple of time.

5. The method according to claim 4, wherein determining the reference value by using the objective function based on the first inverter voltage frequency, the preset rated voltage peak value of the inverter, the preset sampling period, and the preset disturbance frequency, comprises:

   determining an objective curve corresponding to the objective function based on the first inverter voltage frequency, the preset rated voltage peak value, the preset sampling period, and the preset disturbance frequency; and

   using a minimum value of the objective curve as the reference value.

6. The method according to claim 4, further comprising:

   obtaining a first function and a second function; where the first function is used to simulate the inverter voltages of the inverter at the preset rated voltage peak and at the first inverter voltage frequency, and the second function is used to simulate the inverter voltages of the inverter at the preset rated voltage peak and at the second inverter voltage frequency; and

determining the objective function based on the first function and the second function;

wherein the first function is $Fun1(t) = Vrate*\cos(2\pi*Finv*T1*t)$, and the second function is $Fun2(t)=Vrate*\cos[2\pi*(Finv+\Delta F)*T1*t]$.

7. A device for detecting relay sticking in a grid-connected power system, **characterized by** comprising:

an adjustment module, configured to adjust a first inverter voltage frequency of an inverter to obtain a second inverter voltage frequency, wherein the second inverter voltage frequency is equal to a sum of the first inverter voltage frequency and a preset disturbance frequency;

an acquisition module, configured to acquire a plurality of voltage data points at the second inverter voltage frequency, wherein each voltage data point comprises a grid voltage and an inverter voltage of the inverter;

a first determining module, configured to determine a comparison value based on a difference between the grid voltage and the inverter voltage in each voltage data point; and

a second determining module, configured to determine a relay sticking detection result based on the comparison value and a reference value.

8. A computer apparatus, comprising a memory and a processor, wherein the memory has a computer program stored thereon, wherein the processor, when executing the computer program, performs steps of the method according to any one of claims 1 to 6.

9. A computer-readable storage medium, having a computer program stored thereon, wherein the computer program, when executed by a processor, performs steps of the method according to any one of claims 1 to 6.

10. A computer program product, comprising a computer program, wherein the computer program, when executed by a processor, performs steps of the method according to any one of claims 1 to 6.

FIG. 1

FIG. 2

A first inverter voltage frequency of the inverter is adjusted to obtain a second inverter voltage frequency. The second inverter voltage frequency is equal to a sum of the first inverter voltage frequency and a preset disturbance frequency.

S301

A plurality of voltage data points are acquired at the second inverter voltage frequency. Each voltage data point includes a grid voltage and an inverter voltage of the inverter.

S302

A comparison value is determined based on a difference between the grid voltage and the inverter voltage in each voltage data point.

S303

A relay sticking detection result is determined based on the comparison value and a reference value.

S304

FIG. 3

The absolute value of the difference between the grid voltage and the inverter voltage in each voltage data point is determined.

S401

The average of absolute values is determined and used as the comparison value.

S402

FIG. 4

FIG. 5

| | S601 |
|---|---|
| The objective curve corresponding to the objective function is determined based on the first inverter voltage frequency, the preset rated voltage peak value, the preset sampling period, and the preset disturbance frequency. | |

| | S602 |
|---|---|
| The minimum value of the objective curve is used as the reference value. | |

FIG. 6

A first function and a second function are obtained. The first function is used to simulate the inverter voltages of the inverter at the preset rated voltage peak and at the first inverter voltage frequency, and the second function is used to simulate the inverter voltages of the inverter at the preset rated voltage peak and at the second inverter voltage frequency.

S701

The objective function is determined based on the first function and the second function.

S702

FIG. 7

FIG. 8

The first function and the second function are obtained.  S901

The objective function is determined based on the first function and the second function.  S902

The objective curve corresponding to the objective function is determined based on the first inverter voltage frequency, the preset rated voltage peak value, the preset sampling period, and the preset disturbance frequency.  S903

The minimum value of the objective curve is used as the reference value.  S904

The first inverter voltage frequency of the inverter is adjusted to obtain the second inverter voltage frequency, and the second inverter voltage frequency is equal to the sum of the first inverter voltage frequency and the preset disturbance frequency.  S905

The plurality of voltage data points are acquired at the second inverter voltage frequency, and each voltage data point includes the grid voltage and the inverter voltage of the inverter.  S906

The absolute value of the difference between the grid voltage and the inverter voltage in each voltage data point is determined.  S907

The average of the absolute values is determined, and the average is used as the comparison value.  S908

The relay sticking detection result is determined based on the comparison value and the reference value.  S909

FIG. 9

FIG. 10

TRANSLATION

## INTERNATIONAL SEARCH REPORT

International application No.

**PCT/CN2025/110673**

### A. CLASSIFICATION OF SUBJECT MATTER

G01R 31/327(2006.01)i

According to International Patent Classification (IPC) or to both national classification and IPC

### B. FIELDS SEARCHED

Minimum documentation searched (classification system followed by classification symbols)

IPC: G01R

Documentation searched other than minimum documentation to the extent that such documents are included in the fields searched

Electronic data base consulted during the international search (name of data base and, where practicable, search terms used)

CNTXT; ENTXTC; CNKI: ENTXT: 继电器, 粘连, 粘结, 并网, 逆变器, 频率, 扰动, 干扰, 电网电压, 差, 目标函数, relay, sticking, welding, inverter, DC-AC, frequency, disturbance, voltage, difference, objective function

### C. DOCUMENTS CONSIDERED TO BE RELEVANT

| Category* | Citation of document, with indication, where appropriate, of the relevant passages | Relevant to claim No. |
|---|---|---|
| PX | CN 119165348 A (SHENZHEN POWEROAK NEW ENERGY CO., LTD.) 20 December 2024 (2024-12-20) <br> claims 1-10 | 1-10 |
| A | CN 117538739 A (GOODWELL TECHNOLOGY CO., LTD.) 09 February 2024 (2024-02-09) <br> claim 1, and description, paragraphs 52-67 | 1-10 |
| A | CN 110703085 A (AISWEI NEW ENERGY TECHNOLOGY (YANGZHONG) CO., LTD.) 17 January 2020 (2020-01-17) <br> entire document | 1-10 |
| A | CN 115754698 A (QUJING BUREAU OF SUPERVOLTAGE POWER TRANSMISSION CO., LTD., CHINA SOUTHERN POWER GRID) 07 March 2023 (2023-03-07) <br> entire document | 1-10 |
| A | CN 116165531 A (HANGZHOU HOYMILES POWER ELECTRONICS CO., LTD.) 26 May 2023 (2023-05-26) <br> entire document | 1-10 |

☑ Further documents are listed in the continuation of Box C.    ☑ See patent family annex.

| | |
|---|---|
| *   Special categories of cited documents: <br> "A"   document defining the general state of the art which is not considered to be of particular relevance <br> "D"   document cited by the applicant in the international application <br> "E"   earlier application or patent but published on or after the international filing date <br> "L"   document which may throw doubts on priority claim(s) or which is cited to establish the publication date of another citation or other special reason (as specified) <br> "O"   document referring to an oral disclosure, use, exhibition or other means <br> "P"   document published prior to the international filing date but later than the priority date claimed | "T"   later document published after the international filing date or priority date and not in conflict with the application but cited to understand the principle or theory underlying the invention <br> "X"   document of particular relevance; the claimed invention cannot be considered novel or cannot be considered to involve an inventive step when the document is taken alone <br> "Y"   document of particular relevance; the claimed invention cannot be considered to involve an inventive step when the document is combined with one or more other such documents, such combination being obvious to a person skilled in the art <br> "&"   document member of the same patent family |

| Date of the actual completion of the international search | Date of mailing of the international search report |
|---|---|
| **27 October 2025** | **06 November 2025** |

| Name and mailing address of the ISA/CN | Authorized officer |
|---|---|
| **China National Intellectual Property Administration (ISA/ CN)** <br> **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

International application No.

**PCT/CN2025/110673**

| C. | DOCUMENTS CONSIDERED TO BE RELEVANT | |
|---|---|---|
| Category* | Citation of document, with indication, where appropriate, of the relevant passages | Relevant to claim No. |
| A | CN 117434432 A (SHENZHEN ECOFLOW INNOVATION TECHNOLOGY CO., LTD.) 23 January 2024 (2024-01-23) entire document | 1-10 |
| A | CN 118425755 A (SHANGHAI SIGEYUAN INTELLIGENT TECHNOLOGY CO., LTD.) 02 August 2024 (2024-08-02) entire document | 1-10 |
| A | CN 204012679 U (GUANGDONG EAST POWER CO., LTD.) 10 December 2014 (2014-12-10) entire document | 1-10 |
| A | US 2017271871 A1 (TABUCHI DENKI KK) 21 September 2017 (2017-09-21) entire document | 1-10 |
| A | WO 2011065278 A1 (SANYO ELECTRIC CO., LTD. et al.) 03 June 2011 (2011-06-03) entire document | 1-10 |

Form PCT/ISA/210 (second sheet) (July 2022)

**INTERNATIONAL SEARCH REPORT**
**Information on patent family members**

International application No.

**PCT/CN2025/110673**

| Patent document cited in search report | | | Publication date (day/month/year) | Patent family member(s) | | | Publication date (day/month/year) |
|---|---|---|---|---|---|---|---|
| CN | 119165348 | A | 20 December 2024 | None | | | |
| CN | 117538739 | A | 09 February 2024 | None | | | |
| CN | 110703085 | A | 17 January 2020 | None | | | |
| CN | 115754698 | A | 07 March 2023 | None | | | |
| CN | 116165531 | A | 26 May 2023 | None | | | |
| CN | 117434432 | A | 23 January 2024 | None | | | |
| CN | 118425755 | A | 02 August 2024 | None | | | |
| CN | 204012679 | U | 10 December 2014 | None | | | |
| US | 2017271871 | A1 | 21 September 2017 | US | 10418812 | B2 | 17 September 2019 |
| | | | | WO | 2017090139 | A1 | 01 June 2017 |
| | | | | JPWO | 2017090139 | A1 | 24 November 2017 |
| | | | | JP | 6240757 | B2 | 29 November 2017 |
| WO | 2011065278 | A1 | 03 June 2011 | JP | 2011135767 | A | 07 July 2011 |
| | | | | JP | 5682251 | B2 | 11 March 2015 |
| | | | | EP | 2509183 | A1 | 10 October 2012 |

Form PCT/ISA/210 (patent family annex) (July 2022)

**REFERENCES CITED IN THE DESCRIPTION**

**Patent documents cited in the description**

• CN 202411660361